# FASCICULE DE BREVET EUROPEEN

(11) **EP 3 259 969 B1**
(45) Date de publication et mention de la délivrance du brevet: **09.02.2022**
(21) Numéro de dépôt: 16707929.2
(22) Date de dépôt: 16.02.2016
(51) Int. Cl.: H05K 9/00, H01R 13/6598, H01R 13/6463, H01B 11/14

(54) **BLINDAGE MAGNÉTIQUE D'EXTRÉMITÉ DE CÂBLE MULTIFILAIRE**
MAGNETISCHE ABSCHIRMUNG FÜR DAS ENDE EINES MEHRADRIGEN KABELS
MAGNETIC SHIELD FOR THE END OF A MULTIWIRE CABLE

(30) Priorité: 17.02.2015 FR 1551313
(43) Date de publication de la demande: 27.12.2017
(73) Titulaire: Safran Electrical & Power, 31702 Blagnac Cedex (FR)
(72) Inventeur: JULLIEN, Charles, 31330 Grenade (FR); BIESSE, Jean-Luc, 81500 Saint Lieux Les Lavaur (FR)
(74) Mandataire: Ernest Gutmann - Yves Plasseraud S.A.S.
(86) Numéro de dépôt international: PCT/FR2016/050358
(87) Numéro de publication internationale: WO 2016/132065

(56) Documents cités:
- EP-A1- 1 117 285
- EP-A2- 0 716 477
- EP-A2- 0 716 477
- JP-A- H1 140 981
- JP-A- H06 215 639
- JP-A- H06 215 639
- JP-A- 2002 025 356
- JP-A- 2002 198 239
- JP-A- 2002 198 239

## Description

La présente invention concerne le blindage magnétique des câbles électriques. Les extrémités de ces câbles sont en particulier visées.

Typiquement, dans les systèmes électriques, nombre de liaisons filaires, qu'elles véhiculent de la puissance ou des données, sont assurées par des câbles multifilaires torsadés, blindés ou non.

Un blindage électromagnétique est un blindage qui consiste à réduire le champ électromagnétique au voisinage d'un objet en interposant une barrière entre la source du champ et l'objet à protéger. La barrière doit être faite d'un matériau conduisant l'électricité. Les blindages électromagnétiques sont par exemple utilisés pour protéger des équipements des radiofréquences et des parasites électriques.

Un câble blindé est typiquement un câble électrique possédant un blindage sous la forme de fils entourant l'âme du câble. Le blindage supprime ou diminue le rayonnement s'échappant du conducteur et aussi qu'un signal parasite ne s'ajoute au signal/puissance transporté par le conducteur.

Ainsi, le câble est en quelque sorte enfermé dans une cage de Faraday. Dans le cas des câbles multifilaires, on peut utiliser soit un blindage au niveau du câble multifilaire soit des blindages au niveau des câbles unitaires. Le blindage doit être connecté à la masse.

EP0716477A et JP2002198239A concernent le blindage magnétique de câbles électriques.

EP0716477A divulgue ainsi un ensemble pour le blindage magnétique d'un câble électrique, l'ensemble comprenant:
- un câble électrique adapté pour qu'y circule un courant électrique,
- une enveloppe disposée autour dudit câble électrique,
- un connecteur électrique auquel ledit câble électrique est connecté, à une extrémité, ledit câble électrique comprenant plusieurs fils électriques non blindés électromagnétiquement et torsadés ensemble, hormis vers l'extrémité où les fils électriques sont donc non torsadés.

Un problème lié à l'amélioration du blindage demeure.

La solution de l'invention traite cet aspect, en proposant :
- que l'enveloppe soit disposée uniquement autour des fils non torsadés, vers ladite extrémité (où les fils électriques sont non torsadés),
- que l'enveloppe, disposée autour des fils, soit coulissante le long de la partie torsadée, et
- que l'enveloppe soit pourvue de particules magnétisées orientées perpendiculairement à la direction de circulation du courant électrique dans le câble.

Pour une manœuvre aisée de coulissement le long du câble ou des fils, l'enveloppe pourra comprendre une gaine glissée autour dudit câble.

Pour une mise en place, voire un retrait rapide, on pourrait aussi prévoir que l'enveloppe comprenne une bande enroulée autour dudit câble.

Pour une qualité de la protection, il est aussi recommandé que l'enveloppe soit à paroi pleine et entoure de façon circonférentiellement continue les fils qui constituent le câble.

Utiliser, pour l'enveloppe un matériau non conducteur d'électricité, tel une colle ou un vernis, chargé d'un matériau magnétique, tel que des particules de ferrite, permettra une réalisation pratique aisée et l'atteinte de résultats probants.

En réalisant le blindage précité par une enveloppe pourvue de particules magnétisées et disposée autour d'une extrémité du câble, on profite de ce qu'en extrémité le câble est détorsadé et de ce que le câble est typiquement relié, de manière démontable, à un dit connecteur.

Il est par ailleurs connu que, dans le cas de câbles multifilaires, torsader les fils individuels de ces câbles permet une limitation efficace du couplage électromagnétique, tant à l'émission qu'à la réception, entre ces derniers et l'environnement électromagnétiquement proche ; on peut donc éviter que les câbles perturbent ou soient perturbés notablement par cet environnement électromagnétique.

De tels câbles multifilaires torsadés sont typiquement destinés à être insérés dans des connecteurs d'extrémité, lesquels ont pour rôle de relier électriquement entre eux deux câbles à placer bout à bout, ou de raccorder au moins un tel câble à un circuit électrique.

Pour insérer les fils individuels de tels câbles dans un connecteur tout en respectant les normes et les contraintes mécaniques associées aux câbles multifilaires, au connecteur d'extrémité et à l'outillage d'insertion/extraction, il est nécessaire de détorsader les câbles en extrémité.

Or, il s'est avéré que cela suffisait pour dégrader très significativement les performances d'immunité (émission/réception) résultant de la torsade des fils vis à vis des couplages potentiels, électromagnétiquement sensibles ou perturbateurs, proches, en particulier dans le même connecteur.

Une limitation des perturbations est attendue, au moins pour une fréquence de champ magnétique inférieure à 3MHz.

A noter que, vis-à-vis des particules magnétisées, la solution pourrait être moins performante dans la version bande enroulée, car les bandes magnétiques peuvent alors présenter des modifications d'orientations des champs électromagnétiques, de sorte que l'orientation optimum n'est pas assurée et donc l'effet optimum peut ne pas être pleinement effectif.

Selon l'invention, l'enveloppe sera, vers ladite extrémité torsadée, disposée autour desdits fils qui, sous l'enveloppe, seront donc non torsadés et de plus non blindés électromagnétiquement.

En effet, les résultats obtenus présentés plus loin dans la description montrent l'inutilité d'un tel blindage électromagnétique traditionnel tel qu'un treillis ou un guipage de fils entourant l'âme du câble ou d'un des fils électriquement conducteur de celui-ci, ou encore un blindage rigide de type cage de Faraday ou toile d'acier à mailles de taille inférieure à la longueur d'onde à arrêter.

En d'autres termes, on pourra disposer l'enveloppe de l'invention directement autour de la gaine électriquement isolante qui double l'âme électriquement conductrice des fils ou du câble.

Et dès lors que cette enveloppe est disposée coulissante le long de la partie torsadée de ces fils, on laissera libre accès aux fils du câble multifilaire, permettant ainsi aisément les opérations utiles (réparation, maintenance,...) sans compliquer la conception et/ou réalisation des connecteurs, ni nécessiter un raccordement à la masse.

D'autres détails, caractéristiques et avantages de l'invention apparaîtront à la lecture de la description qui va maintenant suivre, faite à titre d'exemple non limitatif en référence aux dessins annexés dans lesquels :
- la figure 1 montre une paire de fils partiellement torsadés ensemble et branchés à un connecteur,
- les figures 2,3 schématisent une solution à enveloppe de protection conforme à l'invention ; figure 2, l'enveloppe est une gaine, figure 3, c'est une bande enroulée,
- la figure 4 montre une solution qui ne fait pas partie de l'invention avec une gaine par fil électrique, et
- la figure 5 illustre des résultats de tests.

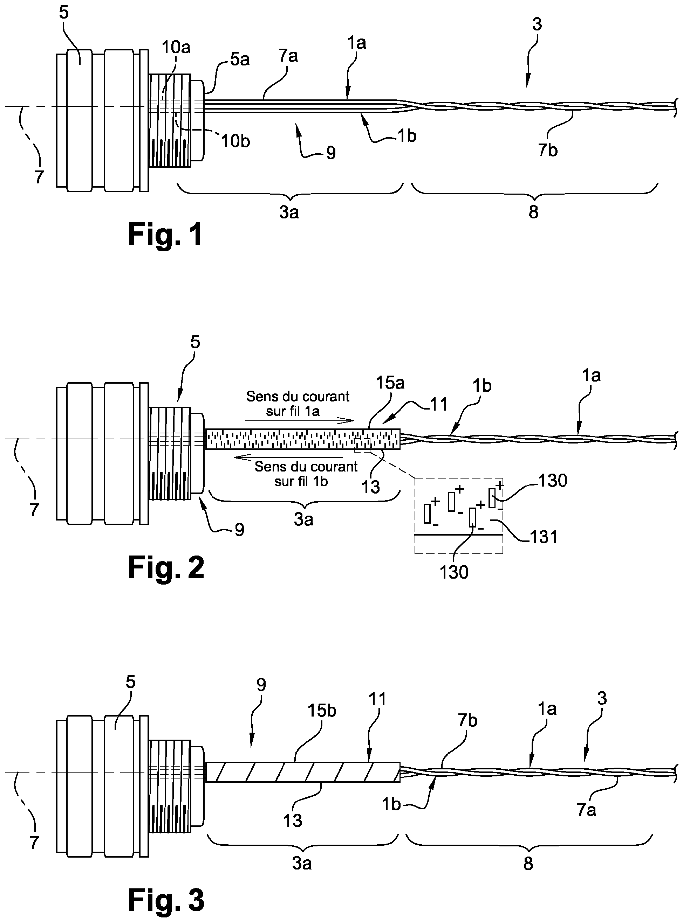

La figure 1 montre donc un schéma d'une paire de fils 1a,1b d'un câble 3 électriquement conducteur.

A une extrémité, chaque fil 1a,1b est dénudé, laissant apparaitre son âme électriquement conductrice, respectivement 10a,10b, pour un raccordement au connecteur aéronautique 5.

Sur le reste de sa longueur, chaque fil 1a,1b est doublé d'une gaine électriquement isolante, respectivement 7a,7b.

Il en serait de même si le câble comprenait un seul fil électriquement conducteur (tel 1a), ou plus de deux fils.

Pour le raccordement, le connecteur 5 présente une face 5a pourvue d'autant d'orifices qu'il y a de fils 1a 1b à raccorder, chacun recevant l'engagement étroit d'un de ces fils. Ici à son extrémité axiale opposée, le connecteur 5 présente en outre une face soit creusée (s'il s'agit d'un connecteur femelle) d'autant d'orifices qu'il y a de broches (ou pins de connexion) d'un autre connecteur (mâle) à y engager pour un accouplement de ces connecteurs, soit de telles broches en nombre identique.

Selon l'invention, le câble bifilaire 3 est torsadé et non-blindé.

De fait, partant de l'extrémité fixée au connecteur 5, les fils 1a,1b sont d'abord non-torsadés sur une portion 3a (fils sensiblement parallèles entre eux et à la direction générale 7 suivant laquelle s'étend le câble), puis, après par exemple 4-8 cm enroulés ensemble (zone 8 fig. 1) suivant cette direction générale 7, a priori sur toute leur longueur, ou du moins jusqu'à proximité de l'extrémité opposée où le même montage sera de préférence prévu.

En outre, cette paire torsadée est ici non-blindée électromagnétiquement ; ainsi, par exemple elle n'est pas recouverte d'un treillis de fils entourant l'âme de chaque (ou des) fil(s).

L'ensemble 9 formé par le câble fixé au connecteur 5 est toutefois dans un état préparatoire sur la figure 1.

Il est par contre conforme à l'invention sur les figures 2 ou 3, où le dispositif 11 de blindage magnétique de l'extrémité 3a du câble 3 comprend une enveloppe 13 disposée dans chaque cas directement autour, au contact, de la (ou de chaque) gaine électriquement isolante doublant l'âme électriquement conductrice du câble.

Figure 2, l'enveloppe est une gaine 15a, figure 3 elle est une bande, 15b.

La bande 15b est enroulée autour du câble. La gaine 15a a été glissée autour du câble.

L'enveloppe 13 entoure totalement le câble 3. Elle peut être à paroi pleine ou continue, sans trou ni aspect maillé ou de treillis. Elle est de préférence flexible, pour suivre la courbure des fils.

Comme déjà indiqué, sur un câble non-blindé, torsader ensemble les fils individuels limite notablement le couplage électromagnétique (en émission et réception) entre ces derniers et l'environnement proche électromagnétiquement sensible ou perturbateur.

Sur la partie extrême 3a non torsadée, ou détorsadée, c'est donc l'enveloppe 13 qui va assurer ce rôle de moyen de limitation du couplage électromagnétique, en basse fréquence, soit moins de3MHz.

Pour cela, on a ici prévu de pourvoir l'enveloppe de particules magnétisées (donc en matériau magnétisable) 130.

En pratique, l'enveloppe 13 pourra comprendre une matière plastique, telle qu'une résine ou colle, ou un vernis 131 imprégné de ces particules magnétisées 130. Cette matière plastique ne conduira pas l'électricité.

Comme montré figure 2 avec son agrandissement local, les particules magnétiques se trouvant dans l'enveloppe 13 qui entoure entièrement le câble 3 sont orientées perpendiculairement à la circulation du courant électrique dans ce câble (voir mentions du sens du courant, fig.2). Les signes + et - marquent le sens d'orientation magnétiques des particules. Ces particules peuvent être par exemple de la poudre de ferrites. Par souci d'efficacité, la longueur de ce blindage 13 sera de préférence suffisante pour couvrir entièrement au moins toute la zone 3a.

Le câble électrique 3 comprend plusieurs fils électriques torsadés ensemble, hormis vers cette extrémité 3a, l'enveloppe sera favorablement constituer par une gaine 15a coulissante disposée uniquement autour de cette partie non torsadés des fils, permettant ainsi de la faire coulisser le long de la partie torsadée par exemple si une intervention sur le connecteur 5 est nécessaire.

Selon l'invention, uniquement vers ladite extrémité 3a, l'enveloppe est disposée autour des fils 1a, 1b qui, sous l'enveloppe, sont non torsadés et non blindés électromagnétiquement. En effet, si le fait de blinder un câble multifilaire a minima limite les perturbations électromagnétiques induites ou supportées par le câble, le torsader génère un effet comparable, en l'espèce. Aussi, combiner les deux permettra essentiellement d'accroître les propriétés mécaniques du câble. Cependant, il demeurera par exemple typiquement nécessaire d'ôter le blindage, voire de détorsader sur une distance suffisante pour insérer les fils dans le connecteur, en extrémité.

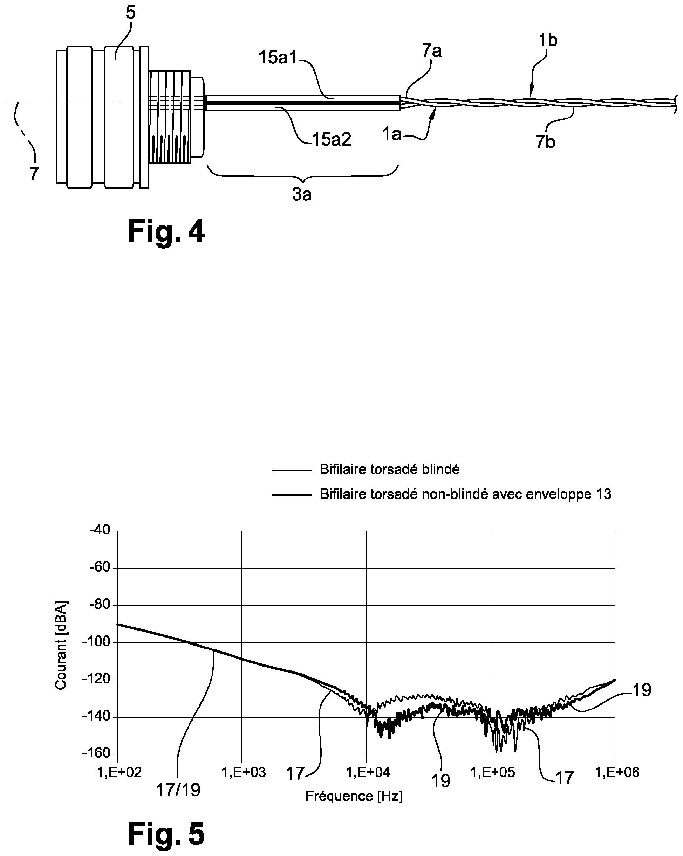

Figure 4, , qui ne fait pas partie de l'invention, ce n'est pas une gaine 15a pour tous les fils électriques qui est prévue, mais une gaine 15a1,15a2 par fil électrique 1a,1b, disposée autour de leur zone d'extrémité non torsadée. Ceci est moins pratique pour la maintenance.

La figure 5 illustre les résultats de tests montrant la diminution des perturbations électromagnétiques alors que la fréquence augmente. La courbe 17 y est celle d'un câble bifilaire de l'art antérieur, torsadé avec un blindage électromagnétique sous la forme d'un guipage de fils entourant le câble, sauf en extrémité où les fils sont détorsadés. La courbe 19 est celle d'un câble bifilaire conforme à l'invention, avec une enveloppe 15a pourvues de particules magnétisées 130 et entourant directement les gaines isolantes des deux âmes électriquement conductrices du câble bifilaire. Dans chaque cas, un câble d'1 m a été électriquement alimenté en mode différentiel sur un générateur de 1V, avec couplage avec un fil voisin. Il peut être constaté que les résultats établis par les courbes 17 et 19 sont très comparables et attestent donc d'une atténuation efficace des perturbations, en basse fréquence, avec la solution de l'invention.

## Revendications

1. Ensemble pour le blindage magnétique d'un câble électrique (3 ; 1a, 1b), l'ensemble comprenant:
- un câble électrique (3 ; 1a, 1b) adapté pour qu'y circule un courant électrique,
- une enveloppe (13) disposée autour dudit câble électrique
- un connecteur électrique (5) auquel ledit câble électrique est connecté, à une extrémité (3a), ledit câble électrique comprenant plusieurs fils électriques (1a,1b) non blindés électromagnétiquement et torsadés ensemble, hormis vers ladite extrémité (3a) où lesdits fils électriques sont donc non torsadés,
**caractérisé en ce que** :
- l'enveloppe (13) est disposée uniquement autour des fils non torsadés, vers ladite extrémité (3a),
- l'enveloppe (13), disposée autour des fils, est coulissante le long de la partie torsadée,
- et l'enveloppe est pourvue de particules magnétisées (130) orientées perpendiculairement à la direction de circulation du courant électrique dans le câble (3).

2. Ensemble selon la revendication 1, où l'enveloppe comprend une bande (15b) enroulée autour dudit câble.

3. Ensemble selon la revendication 1, où l'enveloppe comprend, une gaine (15a) glissée autour dudit câble.

4. Ensemble selon l'une des revendications précédentes, où l'enveloppe (13) est à paroi pleine.

5. Ensemble selon l'une des revendications précédentes, où l'enveloppe comprend un matériau non conducteur d'électricité (131) chargé d'un matériau magnétique, tel que des particules de ferrite (130).

## Patentansprüche

1. Anordnung zur magnetischen Abschirmung eines elektrischen Kabels (3; 1a, 1b), wobei die Anordnung enthält:
- ein elektrisches Kabel (3; 1a, 1b), das dazu ausgelegt ist, dass ein elektrischer Strom darin fließt,
- eine Hülle (13), die um das elektrische Kabel herum angeordnet ist,
- einen elektrischen Verbinder (5), mit dem das elektrische Kabel an einem Ende (3a) verbunden ist, wobei das elektrische Kabel mehrere elektrische Drähte (1a, 1b) umfasst, die nicht elektromagnetisch abgeschirmt und miteinander verdrillt sind, mit Ausnahme von dem Ende (3a), an dem die elektrischen Drähte nicht verdrillt sind,
**dadurch gekennzeichnet, dass**
- die Hülle (13) nur um die nicht verdrillten Drähte zu dem Ende (3a) hin angeordnet ist,
- die Hülle (13), die um die Drähte herum angeordnet ist, entlang des verdrillten Teils verschiebbar ist,
- und die Hülle mit magnetisierten Partikeln (130) versehen ist, die senkrecht zur Richtung des elektrischen Stromflusses in dem Kabel (3) ausgerichtet sind.

2. Anordnung nach Anspruch 1, wobei die Hülle ein Band (15b) aufweist, das um das Kabel gewickelt ist.

3. Anordnung nach Anspruch 1, wobei die Hülle einen Mantel (15a) umfasst, der um das Kabel geschoben ist.

4. Anordnung nach einem der vorhergehenden Ansprüche, wobei die Hülle (13) vollwandig ist.

5. Anordnung nach einem der vorhergehenden Ansprüche, wobei die Hülle ein elektrisch nicht leitendes Material (131) umfasst, das mit einem magnetischen Material, wie etwa Ferritpartikel (130), versetzt ist.

## Claims

1. An assembly for the magnetic shielding of an electrical cable (3; 1a, 1b), with the assembly comprising:
- an electric cable (3; 1a, 1b) adapted for having an electric current to flow therethrough,
- a jacket (13) positioned around said cable,
- an electrical connector (5) which said electric cable is connected to, at one end (3a), said electrical cable comprising several electrical wires (1a, 1b) electromagnetically unshielded and twisted together, except at said end (3a) where said electrical wires are thus untwisted,
**characterized in that**:
- the jacket (13) is positioned around the untwisted wires at said end (3a), only,
- the jacket (13), positioned around the wires, can slide along the twisted portion,
- and the jacket is provided with magnetised particles (130) oriented perpendicularly to the direction of the electric current flow in the cable (3).

2. The assembly according to claim 1, wherein the jacket comprises a band (15b) wound around said cable.

3. The assembly according to claim 1, wherein the jacket comprises a sheath (15a) slipped onto said cable.

4. The assembly according to one of the preceding claims, wherein the jacket (13) is solid-walled.

5. The assembly according to one of the preceding claims, wherein the jacket comprises an electrically non-conductive material (131) charged with a magnetic material, such as ferrite particles (130).
